# EUROPEAN PATENT SPECIFICATION

(11) **EP 0 377 064 B1**
(45) Date of publication and mention of the grant of the patent: **30.03.1994**
(21) Application number: 89100112.5
(22) Date of filing: 05.01.1989
(51) Int. Cl.: G06F 1/14, H03K 23/66, G06F 3/00

(54) **Method of operating a timer**
Arbeitsverfahren eines Zeitmessers
Méthode de fonctionnement d'un temporisateur

(43) Date of publication of application: 11.07.1990
(73) Proprietor: International Business Machines Corporation, Armonk, N.Y. 10504 (US)
(72) Inventor: Getzlaff, Klaus J., Dipl.-Ing., D-7036 Schönaich (DE); Hajdu, Joachim, D-7030 Böblingen (DE); Haller, Wilhelm, Dipl.-Ing., D-7064 Remshalden 1 (DE)
(74) Representative: Dreiss, Fuhlendorf, Steimle & Becker, Patentanwälte

(56) References cited:
- EP-A- 0 019 412
- EP-A- 0 249 128
- ELECTRONICS & WIRELESS WORLD, vol. 92, no. 1607, September 1986, pages 18-23, London, GB; M. CATHERWOOD: "Microcontroller chip includes peripherals"

## Description

The invention relates to a method of operating a timer in an electronic data processing device; in which the contents of at least one timer register is updated once during an update cycle by a predetermined time increment, said update cycle including a predetermined number of operating cycles of the electronic data processing device; in which, during each updating cycle, the contents of an adjustment register is shifted and rotated by one bit position; in which, if the bit value at a particular position of this adjustment register indicates a wait-bit having a predetermined bit value, actual updating of the timer register or registers during one update cycle is omitted; and in which the number p of adjustment bits available to control an equal number of consecutive update cycles, which are available to include an arbitrary number of wait-cycles, before the pattern of wait-bits is repeated, is obtained by the formula 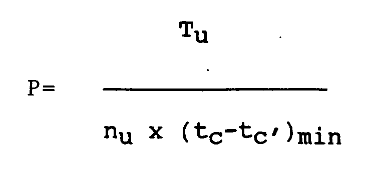
wherein:
- Tᵤ: is the time increment to be added to the contents of a timer register at an update cycle;
- nᵤ: is the number of operating cycles necessary to produce said time increment;
- t_{c}: is the operating cycle time which, without adjustment, produces a time increment after nᵤ operating cycles after a time which is equal to said time increment;
- t_{c'}: is an operating cycle time, which requires adjustment in order to have the number of time increments made after p_{c} consecutive update cycles correspond exactly to the time represented by the time increments;
- (t_{c}-t_{c'})ₘᵢₙ: is the smallest difference between t_{c} and t_{c'}, which shall be corrected by adjustment.

Usually a plurality of timers are implemented in an electronic data processing device for various purposes as e.g. to indicate the time of day, to count predetermined time periods from their beginning down to their end, to compare various time functions with real time, and so on.

Usually, one does not want to provide special clock circuits, including especially adapted oscillators, for this purpose. One rather wants to use the operation cycle of the electronic data device, which is available any way. But to base the operation of such timers on the operation cycle or clock cycle of the data processing device requires, that the time increment used for updating the timers must be a predetermined multiple of the operating cycle time of the data processing device. For example, if the time increment, with which timers are to be updated, is one microsecond, there must exist an integer multiple of the operating cycle time which exactly reoccurs every one microsecond. This integer is equal to the number of times, at which an operating cycle occurs in order to develop an updatesignal. Otherwise updating would be inaccurate. If the time increment is 1 microsecond and updating requires 10 operating cycles, this only can function precisely, if the operating cycle time is exactly 100 nanoseconds.

However, for a number of reasons, such a precise relation suitable for updating the timers is not always available. As a consequence of specific requirements to be met by the processor and/or its basic clock generating oscillator, the operating cycle time of the processor may have "odd" values, from which suitable time increments can not be derived by mere multiplication with an integer. The operating cycle time may e.g. be 99 or 36 nanoseconds. Thus, a different approach is necessary to end up with time increments of exactly 1 microsecond or any other suitable value. Also, circumstances may arise, e.g. during development or with different uses of electronic data processing devices, in which it is advisable to change the operating cycle time and, nevertheless, it is desirable that the timer implementation is such that it can be readily adjusted to such change.

In EP 0 019 412 a method of synthesizing an output frequency and a circuit arrangement thereof is described. For that purpose the value of an input frequency is divided in a calculator by the frequency which is required at the output. Therefore the value of the input frequency is entered into the calculator via a frequency selector. The integral divisor value is used to set the divison ratio of a variable frequency divider. The fractional divisor value is summed cumulatively by a summation circuit, an additional summation being performed each time a pulse is received via an input line from the variable frequency divider. Thus this input line acts as a clock source for the summation circuit. The fractional values are summed cumulatively until the sum exceeds a predetermined value. In this case a gate is opened temporarily under the action of a control signal from the summation circuit to allow the next output pulse obtained from the variable frequency device to pass through a further gate to a pulse subtractor, where a single pulse is subtracted from the pulse stream obtained via the input terminal. In so doing the effective division rate of the variable frequency divider is temporarily increased by one unit, thereafter normal divison continues until the next occasion that the cumulative sum produced by the summation circuit exceeds the predetermined value.

Thus, it is an objective of the present invention to provide a method for operating a timer of the aforementioned type, which easily can be adjusted to various operating cycle times. In particular, the timer should be easily programmable to adapt it to various operating cycle times within a wide range.

This objective is met by providing that the number q of bit positions in an adjustment pattern of the adjustment register is determined such that

$\text{p = n x q}$

where n is an integer, and that the adjustment register further contains a counter and a group correction, wherein said adjustment pattern is shifted and rotated n times during an adjustment period of p update cycles, and wherein said counter indicates the count of update cycles between zero and p and, at predetermined ones of these counts, refers to a particular bit position in the group correction to control omission or execution of updating respectively.

Further improvements of this invention are defined in the subclaims.

The invention thus simply includes into a series of update cycles a check of an adjustment register containing a counter and a group correction, the contents of the adjustment register is shifted and rotated n times during an adjustment period of p update cycles, and, in response to a particular bit value at a particular bit position in the group correction, e.g. a "1" in its leftmost location, controls the execution or omission respectively of a particular update operation. If, for example, during a particular update cycle a bit value of 1 is found in the group correction of the adjustment register, this may be defined to indicate that the next or concurrent update cycle should be a "wait" cycle, during which actual updating is omitted in order to obtain a certain time adjustment, namely an adjustment equal to the duration of one update cycle. In the above example an adjustment is necessary, in case the time increment to be used is 1 microsecond, the number of operating cycles necessary for one update cycle is 10, if the operating cycle is 99 instead of 100 nanoseconds. The accumulative error occuring during each update cycle, will be 10 nsecs, since 10 operating cycles are needed for one update cycle. On the other hand, one update cycle needing 10 operating cycles lasts 10 x 99 ns= 990 ns. Thus, if 99 update cycles are carried out "normally", and during one further update cycle, actual updating is omitted, then after 100 update cycles, the actual time lapsed would be (99+1) x 990 nsecs. = 99000 nsecs.= 99 microsec., involving not (99+1), but rather 99 updates of an 1 usec increment, which is exactly the same as it would be in the case of 99 update cycles each involving 10 operating cycle times of 100 ns, but without omitting the update operation during one "wait-cycle.

Thus, it can easily be seen that over a certain length of time, by properly omitting the execution of updates during predetermined ones of the update cycles, adjustment can be achieved. Nevertheless, the maximum time error, which can accumulate between adjustments, will always be less than the time increment used for updating the timer. Further, since the control of execution or omission of updates during particular update cycles depends on the bit value at a particular position of the adjustment register, adjustment can easily be programmed to meet various different situations.

Further details and advantages of the invention will become apparent from the following description of embodiments, which will be made by reference to the accompanying drawings, in which:
- Figure 1: is a diagram illustrating the software embodiment of the invention;
- Figure 2: is a diagram explaining the relation of operating cycles to one update cycle;
- Figure 3: is a hardware embodiment;
- Figure 4: illustrates a part of the hardware embodiment.

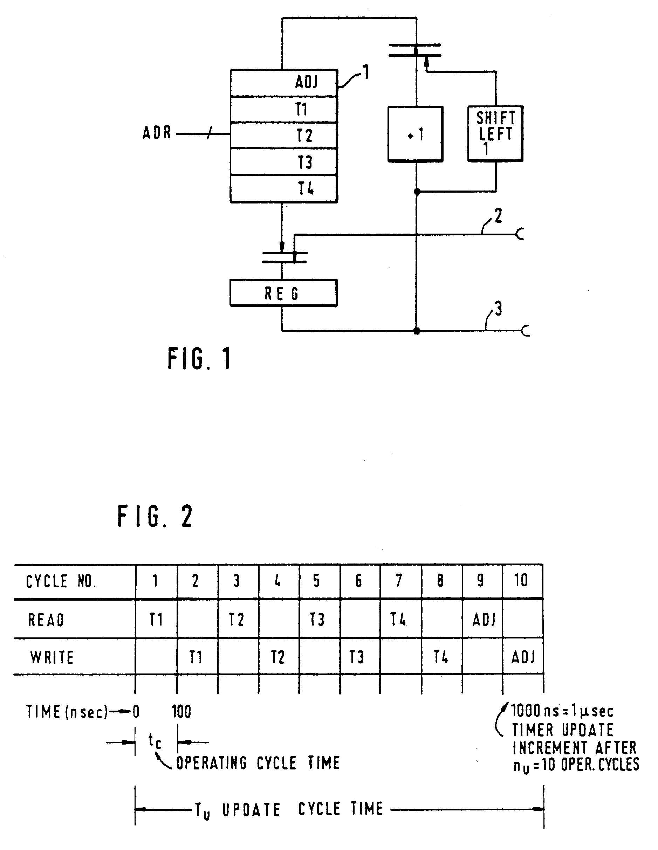

As illustrated in fig. 1, an array 1 includes four timers T₁, T₂, T₃ and T₄. It further includes an adjustment register ADJ. The timers may have various functions, e.g. time of day, intervall counting, CPU timer function, clock comparator. The timers T₁...T₄ are implemented by registers. Each of these registers is updated once during one update cycle. If, for example, the timer shall indicate the time of day, than, once during each updating cycle, and this means: after each update cycle time Tᵤ, a time increment corresponding to Tᵤ is added to the contents of the particular timer register. This updating is symbolized in fig. 1 by the step "+1" in the loop. If the time increment corresponding to the duration of the update cycle is developed from the operating cycle time t_{c}, it should have a value, which easily can be related to the time increments to be added to the timer registers every update cycle. In other words: If the time increment to be added to a timer register is e.g. 1 and actually denotes 1 µsec, it is necessary that the update cycle time Tᵤ also is 1 µsec. This can easily be achieved, if Tᵤ is a multiple of the operating cycle time, i.e. if Tᵤ is equal to nᵤ x t_{c} , where nᵤ is an integer. This is the situation depicted in Fig. 2, when an update cycle includes 10 operating cycles, each having an operating cycle time t_{c} of 100 nanoseconds, resulting in an update cycle time Tᵤ = 10 x 100 nanoseconds= 1000 nsec or 1 µsec. The fact that, in this example, 10 operating cycles are included in one update cycle results from the fact that one READ and one WRITE OPERATION for 5 registers are necessary for one update cycle, namely for the registers T₁, T₂, T3, T₄ and ADJ, the function of this latter one to be explained later. If these relations hold, no adjustment is necessary. The adjustment register ADJ actually would not be needed.

However, it may be that the processor operating cycle time t_{c}, as explained, for other reasons has an "odd" value. Let it be assumed, for example, that t_{c} is equal to t_{c′}=99 nanoseconds. Thus, the update time increment accumulated after 10 operating cycles is T_{u'} = 10 x 99 nsec. = 990 nsec, resulting in an error ${\text{ΔT=(T}}_{\text{u}} {\text{- T}}_{\text{u′}} \text{) = 10 nsecs}$ per update cycle.

Without any adjustment, after 99 update cycles, each including 10 operating cycles of 99 nsec, this error will have accumulated to a total error of 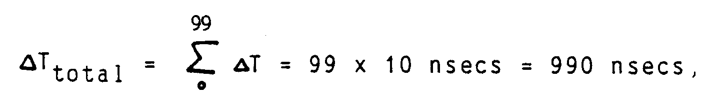
which actually is equal to one update cycle time period T_{u′}.

Thus, it is apparent, in the example given above, that an adjustment for elimination of this error will be achieved, if, after 99 update cycles, each including one updating operation, during one following update cycle updating is omitted. This means that 99 actual updates will have occured after a total time of
^{T}total=(99+1)x T_{u′} = 100 x 990 nsec = 99 000 nsecs = 99 µsecs.

Since 99 time increments each corresponding to 1 µsec will have been added to a particular timer register during this time, which actually is equal not to 99 but rather 100 update cycles, this means that adjustment to recover perfect accuracy is made after 100 update cycles, if updating is omitted during one of them. This adjustment is controlled by the contents of the adjustment register ADJ.

Suppose, in the above example, the adjustment register ADJ has an adjustment pattern field of 100 bits, of which the leftmost is 1, the other ones all being 0. Now, if the contents of this register is shifted to the left by 1 position during each update cycle and the leftmost bit shifted out of the register is written into it again in the rightmost position, in other words: if the contents of the adjustment register ADJ is made to shift and rotate during each update cycle, then the one particular bit having the value 1 will reappear in the leftmost position of the adjustment pattern field every 100th update cycle. The value "1" of the bit at this particular position of the adjustment register ADJ thus can be used to control the adjustment process. If, in the example given above, adjustment is omitted, if a "1" appears at the leftmost position of the adjustment register ADJ, this occurs once in 100 update cycles and thus provides exact adjustment. A bit having the value "1" may be called a "wait"-bit. This shift and rotate operation is symbolized in Fig. 1 by the block "SHIFT LEFT 1" in the loop.

Since the contents of the adjustment register ADJ is programmable, the control of omission of update operations during a particular one of the updating cycles can be programmed to meet different requirements. For example, if the operating cycle time t_{c} is 36 nsecs, the error occuring during one update cycle of 10 operating cycles is

${\text{ΔT = T}}_{\text{u}} {\text{- T}}_{\text{u′}} \text{) = 1000 - (10x36) = 640 nsecs}$

per one update cycle. The total accumulative error during 36 update cycles amounts to

${\text{ΔT}}_{\text{total}} \text{= 36 + 640 = 23 040 nsecs = 23,04 µsecs.}$

However, if during the occurrence of 36 update cycles of T_{u′}=360 nsecs, each with actual execution of an update operation, 64 further update cycle, are inserted (either as a block or distributed), during which updating actually is omitted, the total time, during which 36 updates of increments corresponding each to 1 µsec would have been made, including 64 update cycles, which are "wait"-cycles, since updating has been suppressed, is

${\text{T}}_{\text{total}} {\text{= (36 + 64) x T}}_{\text{u′}} \text{= 100 x 360 nsecs = 36 µsecs.}$

This means that perfect adjustment is made. The 100 bit adjustment field of the adjustment register ADJ in this case can be composed of 4 blocks of 25 bits. Each block would contain 16 wait-bits having the value 1 and 9 bits having the value 0. The bit distribution in each block could, for example, be as follows:
0110101101011011011011011.

This block is repeated 4 times such that the total adjustment pattern of 100 bits in adjustment register ADJ includes 64 wait bits "1", meaning that, within a greater frame of 100 "update" cycles, during 64 cycles the actual updating is omitted. In a strict meaning, they are no longer "update" cycles. But this nomenclature is maintained for simplicily reasons and the distinction is made between update cycles, within which updating actually is executed and update cycles, within which it is omitted). During update 36 cycles, updating is executed as usual. Since at most 2 wait bits needing an update cycle time T_{u′} = 360 nsecs are arranged consecutively in the above 25-bit block, the maximum error in an operating cycle of t_{c′} = 36 nsecs is 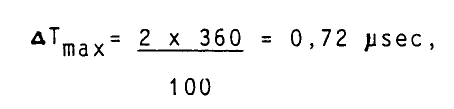
Thus, the maximum error is less than the resolution of 1 µsec.

The time period, after which exact adjustment is obtained, is equal to the duration of the 25 bit block indicated above, i.e. 25 x 360 n secs = 9,0 µsecs.

The number of control bits in the adjustment pattern (in register ADJ) depends on the smallest error per update cycle, which shall give cause to adjustment. This is the minimum of the difference between the desirable operating cycle time t_{c} and the actual operating cycle time t_{c′}. It is (t_{c}-t_{c′})nsecs. In the above example, this error per update cycle period Tᵤ was ΔT= 10 nsecs, resulting from an operating cycle time error of 1 nsec (99 instead of 100) occurring during since 10 operating cycles per one update cycle. The time increment Tᵤ for the timers T₁...T₄ was 1 µsec = 1000 nsecs. The necessary number p of control bits in the adjustment pattern therefore should be

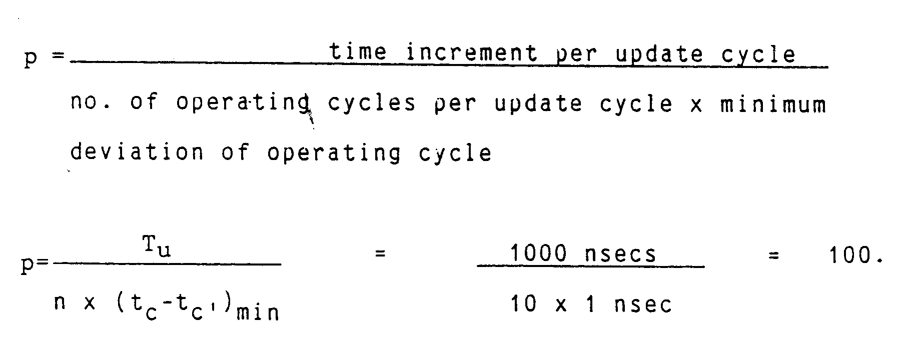

Granularity of adjustment can be defined as the smallest possible actual operating cycle time period t_{c′}, which can be adjusted. In the above example, the desired updating time increment being Tᵤ=1000 nsecs, the number p_{c} of adjustment bits being 100, and the number nᵤ of operating cycles per update cycle being 10, the granularity is 1 nsec. This means that the smallest possible actual cycle time t_{c′}, which still can be accounted for by adjustment, is 1 nsec.

For the example given above, it was shown that 100 control bits are needed. Thus, during 100 update cycles, at most 99 wait cycles could be included after one normal update cycle.

In order to meet actual timer and array widths, the contents of adjustment register ADJ, should be compressed e.g. to a field of 30 bits. This can, for example, be done by providing a pattern, in which 7 bits (0...6) indicate the value of a 7-bit counter, counting the update cycles from 0 to 100, 20 bits (7...26) represent the adjustment pattern in the sense discussed above, i.e. to control the update operation, and 4 further bits (27...30) are used as group correction bits. Such a 30-bit compressed field pattern would look as follows: 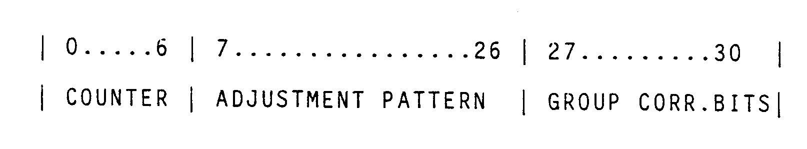
The number qu of bit positions in the adjustment pattern is 20. This adjustment pattern of 20 bits would be sufficient, if the number of wait cycles to be included during 100 update cycles would be divisible by 5 or, in other words, if a relation $\text{p=n x q}$ , where n is an integer, exists. Then, during 100 update cycles, the 20 bit adjustment pattern would be read 5 times and, due to the shift and rotation operation, the number of wait bits "1" included in this 20 bit adjustment pattern, multiplied by 5, would result in the desired number of wait bits.

However, let us assume, as in the example give above, that the number of wait bits to be included during 100 update cycles, is 64. If in each 20-bit-adjustment pattern shown above, 12 wait-bits having the value 1 are included, a remainder of 4 is left. These additional 4 wait bits are provided as follows:
Each time, the 20-bit-adjustment pattern is shifted by 1, the counter, provided by the 7 bits 0...6, will count one step further. Since the counter is made up by 7 bits, it can - theoretically - count from 0 to 127, and assume 128 (2⁷) possible values. However, the counter wraps to '0' at value '99'. Four of these values, e.g. values 20, 40, 60, 80, can be predetermined and a particular one of the group correction bits assigned to it. Thus, if one of these counter values is decoded, the assigned group correction bit can be investigated and, if it is "1", use to control omission of updating. Thus, 4 further wait cycles can be added by predetermining 4 values of the counter and assigning to each value one group correction bit, and further by adding a "wait"-cycle each time the assigned group correction bit is "1".

A further simplification can be achieved by an adjustment field, in the adjustment register ADJ, which is constructed as follows:

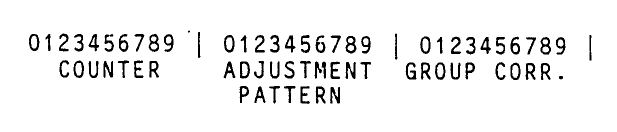

As shown, there are 30 bits in 3 fields, each with 10 bits, namely counter, an adjustment pattern and group correction.

The 10-bit adjustment pattern is used as described above, i.e. with each update cycle the field is made to shift and rotate to the left by 1, i.e. the bit at the leftmost position is written into the rightmost position, whilst all other bits are shifted by one to the left. If the leftmost bit is "1", it is a "wait"-cycle and updating is omitted.

The 10-bitcounter defines a decimal carry. If, for example, the number of wait cycles is 64, the decimal carry to be defined in the counter field is 6. This is indicated by a "1" in bit position 6, whilst the bits at all other bit positions are "0". This pattern is shifted by 1 and rotated 1 bit per each update cycle as is the adjustment pattern.

Each time, a "1" appears in the leftmost position of the counter the leftmost bit of group correction is used to control the updating, i.e. if, at this instant, the leftmost bit of the group correction is "1", a wait cycle is added.

Each time the counter field has been shifted and rotated once completely, the group correction field is shifted by 1 bit. In the example, given above, in which the number of wait cycles is 64, 4 bits having the value "1" are included in the group correction field.

This arrangement essentially has the advantage over the arrangement described before, that no decoding is necessary and that for all patterns shift/rotate operations are to be carried out only.

To complete the description of Fig. 1, it is added that line 2 illustrates an external set but, which line 3 illustrates an external read bus. REG is a buffer register, in which the momentary contents of the timers is held available for read out.

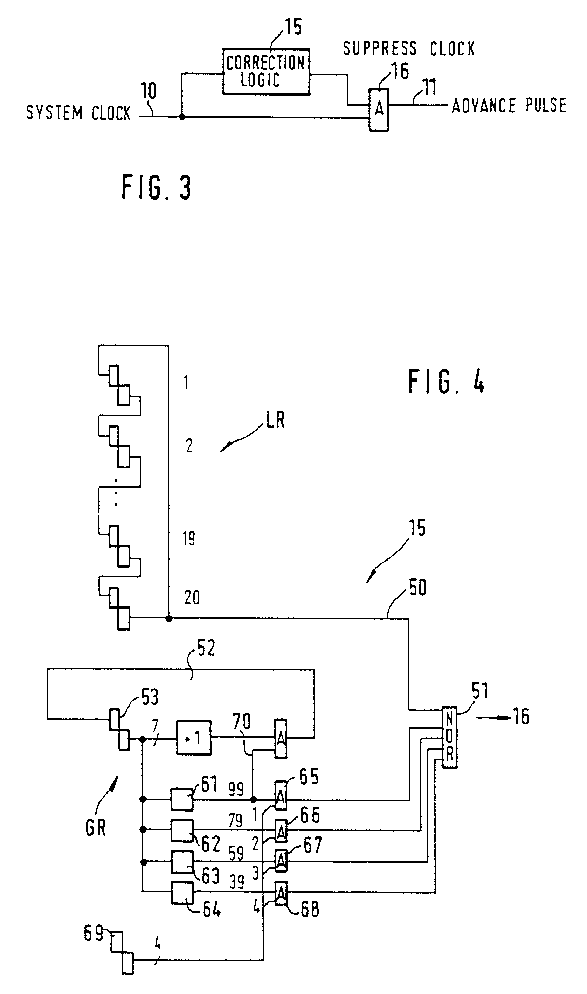

Fig. 3 and 4 show a hardware implementation of described method. In Fig. 3, an advance pulse on line 11 for the timer logic is derived from a system clock supply line 10 by means of an AND-Gate 16. This advance pulse, however, is suppressed by a "suppress clock"-pulse on line 13, which is derived by correction logic 15.

The correction logic 15 is shown in fig. 4, in which LR is a latch-ring with 20 storage places, 1, 2, ..., 19, 20. This latch-ring corresponds to an 20 bit adjustment pattern in the software implementation. Each update cycle shifts the contents of latch-ring LR by one. If a "1" is shifted into position 20, it also appears via line 50 on the input of NOR-Gate 57, which then delivers a "0"-output to AND-Gate 16 and thereby suppesses the development of an advance pulse on line 11 in response to a system Clock pulse on line 10.

Further, GR represents the group correction circuit, which in its function corresponds to the group correction field in the software embodiment. Loop 52, register 53, and the block "+1" represent a 7-bit-counter, which is advanced by 1 each update cycle. As explained in connection with the software implementation, a 20- bit-adjustment field to be used to insert wait-bits in a 100 update cycle block, must be expanded with the possibility to add 4 further wait cycles during 100 update cycles. Therefore, 4 decoders 61, 62, 63, 64 are provided to decode 4 arbitrarily predeterminable count values during a 100 counted updated cycles, e.g. the 39, 59, 79, 99, as indicated. Through AND-gates 65, 66, 67, 68 they will produce further inputs to NOR-gates 51, if at the second inputs of AND-gates 65, 66, 67, 68 also bits of value "1" will have been delivered from the 4-bit group correction register 69. If a "1" bit from group correction register 69 coincides at the input of one of the AND-gates 65, 66, 67, 68 with the decoding of a preselceted value of the 7-bit-counter 52, 53, a further "0"-output will be delivered from NOR-gate 51 and thereby suppress an advance pulse on line 11, since the AND-function is not fulfilled at the inputs of AND-gate 16. A signal appearing on line upon decoding of value 99 by decoder 61 will reset register 53 to zero and restart the count to 100 of the counter.

## Claims

1. Method of operating a timer in an electronic data processing device; in which the contents of at least one timer register (T₁,T₂,T₃,T₄) is updated once during an update cycle by a predetermined time increment, said update cycle including a predetermined number (nᵤ) of operating cycles of the electronic data processing device; in which, during each updating cycle, the contents of an adjustment register (ADJ) is shifted and rotated by one bit position; in which, if the bit value at a particular position of this adjustment register (ADJ) indicates a wait-bit having a predetermined bit value, actual updating of the timer register or registers (T₁,T₂,T₃,T₄) during one update cycle is omitted; and in which the number p of adjustment bits available to control an equal number of consecutive update cycles, which are available to include an arbitrary number of wait-cycles, before the pattern of wait-bits is repeated, is obtained by the formula 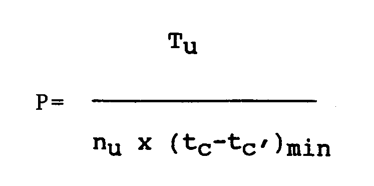 wherein:
Tᵤ is the time increment to be added to the contents of a timer register at an update cycle;
nᵤ is the number of operating cycles necessary to produce said time increment;
t_{c} is the operating cycle time which, without adjustment, produces a time increment after nᵤ operating cycles after a time which is equal to said time increment;
t_{c'} is an operating cycle time which requires adjustment in order to have the number of time increments made after P_{c} consecutive update cycles correspond exactly to the time represented by the time increments;
(t_{c}-t_{c'})ₘᵢₙ is the smallest difference between t_{c} and t_{c'}, which shall be corrected by adjustment,
**characterized in that** the number q of bit positions in an adjustment pattern of the adjustment register (ADJ) is determined such that
$\text{p = n x q}$
where n is an integer, and in that the adjustment register (ADJ) further contains a counter and a group correction, wherein said adjustment pattern is shifted and rotated n times during an adjustment period of p update cycles, and wherein said counter indicates the count of update cycles between zero and p and, at predetermined ones of these counts, refers to a particular bit position in the group correction to control omission or execution of updating respectively.

2. Method according to claim 1, characterized in that the counter field is decoded in order to determine said predetermined ones of said counts.

3. Method according to claim 1, characterized in that the counter is composed of one bit with a first bit value, all other bits being of a second bit value, and in that the counter field is shifted and rotated by 1 during each update cycle and in that reference is made by the counter field to the group correction field by said one first bit value occuring at a particular bit position, and in that the group correction field is shifted and rotated by 1 for each complete shift and rotation of the adjustment and the counter field.

## Patentansprüche

1. Arbeitsverfahren eines Zeitmessers in einer elektronischen Datenverarbeitungsvorrichtung; wobei der Inhalt wenigstens eines Zeitmesserregisters (T₁, T₂, T₃, T₄) einmal während eines Aktualisierungszyklusses um ein zuvor festgelegtes Zeitinkrement aktualisiert wird, wobei der Aktualisierungszyklus eine zuvor festgelegte Zahl (nᵤ) von Befehlszyklen der elektronischen Datenverarbeitungsvorrichtung einschließt; wobei der Inhalt eines Anpassungsregisters (ADJ) während jedes Aktualisierungszyklusses um eine Bitposition verschoben und rotiert wird; wobei, wenn der Bitwert an einer bestimmten Stelle dieses Anpassungsregisters (ADJ) anzeigt, daß ein Wartebit einen vorher festgelegten Wert hat, die anstehende Aktualisierung des Zeitmesserregisters oder der Zeitmesserregister (T₁, T₂, T₃, T₄) während eines Aktualisierungszyklusses ausgesetzt wird; und wobei die Zahl p von Anpassungsbits, die zur Steuerung einer gleichen Zahl von aufeinanderfolgenden Aktualisierungszyklen bereitstehen, die zur Verfügung stehen, um eine beliebige Zahl von Wartezyklen einzuschließen, bevor das Muster von Wartebits wiederholt wird, durch folgende Formel gegeben ist: 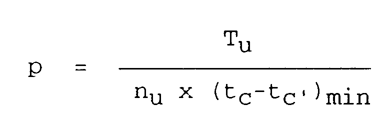 wobei:
Tᵤ das Zeitinkrement ist, das bei einem Aktualisierungszyklus zum Inhalt des Zeitmesserregisters zu addieren ist;
nᵤ die Zahl der Befehlszyklen ist, die zur Erzeugung des Zeitinkrements notwendig ist;
t_{c} die Befehlszykluszeit ist, die - ohne Anpassung - nach nᵤ Befehlszyklen ein Zeitinkrement produziert, nach einer Zeit, die gleich dem Zeitinkrement ist;
t_{c'} eine Befehlszykluszeit ist, die eine Anpassung erfordert, damit die Zahl der Zeitinkremente, die nach p_{c} aufeinanderfolgenden Aktualisierungszyklen erzeugt worden sind, genau der Zeit entspricht, die durch die Zeitinkremente dargestellt wird;
(t_{c}-t_{c'})ₘᵢₙ die kleinste Differenz zwischen t_{c} und t_{c'} ist, die durch die Anpassung berichtigt werden soll,
**dadurch gekennzeichnet, daß** die Zahl q der Bitpositionen in einem Anpassungsmuster des Anpassungsregisters (ADJ) so festgelegt wird, daß
$\text{p = n x q ,}$
wobei n eine ganze Zahl ist, und dadurch, daß das Anpassungsregister (ADJ) ferner einen Zähler und eine Gruppenkorrektur enthält, wobei das Anpassungsmuster während einer Anpassungsperiode aus p Aktualisierungszyklen n-mal verschoben und rotiert wird und wobei der Zähler die Zahl der Aktualisierungszyklen zwischen null und p anzeigt und bei zuvor festgelegten Zahlen eine spezielle Bitposition in der Gruppenkorrektur anspricht, um die Aussetzung bzw. Ausführung der Aktualisierung zu steuern.

2. Verfahren gemäß Anspruch 1, dadurch gekennzeichnet, daß das Zählerfeld decodiert wird, um diese zuvor festgelegten Zahlen festzustellen.

3. Verfahren gemäß Anspruch 1, dadurch gekennzeichnet, daß der Zähler sich aus einem einzigen Bit mit einem ersten Bitwert zusammensetzt, wobei alle anderen Bits einen zweiten Bitwert haben, und dadurch, daß das Zählerfeld in jedem Aktualisierungszyklus um 1 verschoben und rotiert wird, und dadurch, daß das Zahlerfeld das Gruppenkorrekturfeld durch diesen einen ersten Bitwert anspricht, der an einer bestimmten Bitposition erscheint, und dadurch, daß das Gruppenkorrekturfeld für jedes vollständige Durchschieben und Durchrotieren der Anpassung und des Zählerfeldes um 1 verschoben und rotiert wird.

## Revendications

1. Méthode de fonctionnement d'un temporisateur dans un dispositif de traitement de données électronique, dans laquelle le contenu d'au moins un registre temporisateur (T1, T2, T3, T4) est mis à jour une fois durant un cycle de mise à jour sur un incrément de temps prédéterminé, ledit cycle de mise à jour comprenant un nombre prédéterminé nᵤ de cycles opératoires du dispositif de traitement de données électronique; dans laquelle, durant chaque cycle opératoire, le contenu d'un registre de réglage (ADJ) est décalé et soumis à rotation sur une position binaire; dans laquelle, si la valeur binaire d'une position particulière de ce registre de réglage (ADJ) indique un bit d'attente ayant une valeur binaire prédéterminée, il est omis une mise à jour véritable du registre, ou des registres, temporisateur (T1, T2, T3, T4) durant un cycle de mise à jour; et dans laquelle le nombre p de bits de réglage disponibles pour contrôler un nombre égal de cycles de mise à jour consécutifs, qui sont disponibles pour inclure un nombre arbitraire de cycles d'attente, avant que ne soit répétée la configuration de bits d'attente, est obtenu par la formule 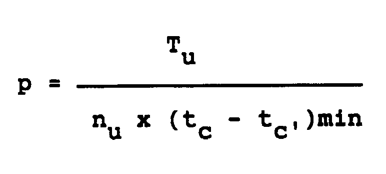 dans laquelle
Tᵤ est l'incrément de temps à ajouter au contenu d'un registre temporisateur à un cycle de mise à jour;
nᵤ est le nombre de cycles opératoires nécessaires pour produire ledit incrément de temps;
t_{c} est le temps de cycle opératoire qui, sans réglage, produit un incrément de temps après nᵤ cycles opératoires après un temps qui est égal audit incrément de temps;
t_{c'} est un temps de cycle opératoire qui exige un réglage de manière à ce que le nombre d'incréments de temps après p_{c} cycles de mise à jour consécutifs corresponde exactement au temps représenté par les incréments de temps;
(t_{c}-t_{c'})min est la plus petite différence entre t_{c} et t_{c'} qui va être corrigée par réglage,
caractérisée en ce que le nombre q de positions binaires dans une configuration de réglage du registre de réglage (ADJ) est déterminé de sorte que
$\text{p = n x q}$
où n est un nombre entier, et en ce que le registre de réglage (ADJ) contient en outre un compteur et une correction de groupe, dans lequel ladite configuration de réglage est décalée et soumise à une rotation de n fois durant une période de réglage de p cycles de mise à jour, et dans lequel ledit compteur indique le compte de cycles de mise à jour entre zéro et p et, à des comptes prédéterminés de ces comptes, désigne une position binaire particulière dans la correction de groupe pour contrôler respectivement l'omission ou l'exécution d'une mise à jour.

2. Méthode selon la revendication 1, caractérisée en ce que le champ de compteur est décodé de manière à déterminer lesdits comptes prédéterminés desdits comptes.

3. Méthode selon la revendication 1, caractérisée en ce que le compteur est composé d'un bit avec une première valeur binaire, tous les autres bits ayant une deuxième valeur binaire, et en ce que le champ de compteur est décalé et soumis à une rotation de 1 durant chaque cycle de mise à jour, et en ce qu'il est fait référence par le champ de compteur au champ de correction de groupe par ladite une première valeur binaire apparaissant à une position binaire particulière, et en ce que le champ de correction de groupe est décalé et soumis à une rotation de 1 pour chaque opération de décalage et rotation complète du champ de réglage et de compteur.
